**Europäisches Patentamt**

**European Patent Office**

**Office européen des brevets**

(11) Veröffentlichungsnummer : **0 019 758
B1**

(12) **EUROPÄISCHE PATENTSCHRIFT**

(45) Veröffentlichungstag der Patentschrift :
**05.10.83**

(21) Anmeldenummer : **80102474.6**

(22) Anmeldetag : **06.05.80**

(51) Int. Cl.³ : **H 01 L 29/60, H 01 L 29/10,
H 01 L 29/78, H 01 L 21/28**

(54) **Feldeffekttransistor mit kurzer Kanallänge und Verfahren zu dessen Herstellung.**

(30) Priorität : **28.05.79 DE 2921600**

(43) Veröffentlichungstag der Anmeldung :
**10.12.80 Patentblatt 80/25**

(45) Bekanntmachung des Hinweises auf die Patenterteilung : **05.10.83 Patentblatt 83/40**

(84) Benannte Vertragsstaaten :
**FR GB IT**

(56) Entgegenhaltungen :
**DE A 2 753 613
FR A 1 441 133
FR A 2 396 414
FR A 2 396 415
US A 4 058 822**

(73) Patentinhaber : **SIEMENS AKTIENGESELLSCHAFT
Berlin und München Wittelsbacherplatz 2
D-8000 München 2 (DE)**

(72) Erfinder : **Takacs, Dezsö, Dipl.-Phys.
Entenbachstrasse 16
D-8000 München 90 (DE)**
Erfinder : **Pfleiderer, Hans-Jörg, Dr.
Franz-Krinninger-Weg 23
D-8011 Zorneding (DE)**
Erfinder : **Hebenstreit, Ernst, Dipl.-Ing.
Gunzenlehstrasse 26
D-8000 München 21 (DE)**
Erfinder : **Pomper, Michael, Dipl.-Ing.
Miesbacher Strasse 34
D-8126 Schliersee (DE)**
Erfinder : **Klar, Heinrich, Dr.
Rossmarkt 8
D-8000 München 2 (DE)**

Feldeffekttransistor mit kurzer Kanallänge und Verfahren zu dessen Herstellung

Die Erfindung bezieht sich auf einen Feldeffekttransistor, der an der Grenzfläche eines mit einer Grunddotierung versehenen Halbleiterkörpers liegende, zu der Grunddotierung entgegengesetzt dotierte Source- und Draingebiete sowie ein erstes und ein zweites Gate aufweist, die jeweils einen Teil des zwischen den Gebieten liegenden Halbleiterbereiches überdecken und von diesem durch eine elektrisch isolierende Gateisolierschicht getrennt sind, bei dem das erste Gate sourceseitig selbstjustierend angeordnet und mit einer Steuerspannung beschaltet ist, während das zweite Gate drainseitig selbstjustierend angeordnet und mit einer Vorspannungsquelle verbunden ist, bei dem das zweite Gate aus einer elektrisch leitenden Belegung besteht, die teilweise oberhalb des ersten Gate angeordnet und durch eine zweite elektrisch isolierende Schicht von diesem getrennt ist, bei dem der von dem ersten Gate nicht bedeckte Teil des zwischen den Gebieten liegenden Halbleiterbereiches mit einer der Grenzfläche benachbarten Zone versehen ist, die eine zu der Grunddotierung entgegengesetzte Dotierung aufweist, und bei dem der Kanalbereich zwischen dem Sourcegebiet und der benachbarten Zone liegt und vom Sourcegebiet und von der benachbarten Zone begrenzt ist.

Ein Feldeffekttransistor dieser Art ist aus der FR-A-2 396 415 bekannt.

Ein anderer Feldeffekttransistor, der ähnlich aufgebaut ist, jedoch keine der Grenzfläche benachbarte Zone mit einer zur Grunddotierung entgegengesetzten Dotierung in dem von dem ersten Gate nicht bedeckten Teil des zwischen dem Sourcegebiet und dem Draingebiet liegenden Halbleiterbereiches aufweist, ist aus der DE-OS-27 29 656 bekannt. Dabei überdeckt ein erstes isoliert auf einem Halbleiterkörper aufgebrachtes Gate den zwischen dem Source- und Draingebiet liegenden Halbleiterbereich mit Ausnahme eines streifenförmigen Halbleitergebiets, welches unmittelbar an das Sourcegebiet angrenzt. Ein zweites Gate, das teilweise oberhalb des ersten angeordnet ist und durch eine Isolierschicht von diesem getrennt ist, überdeckt dieses streifenförmige Gebiet. Das zweite Gate wird mit einer Steuerspannung beschaltet, während das erste Gate mit einer Vorspannquelle verbunden ist. Bei einem solchen Feldeffekttransistor hängt jedoch die wirksame Kanallänge, die mit der in Source-Drain-Richtung gemessenen Breite des streifenförmigen Gebiets übereinstimmt, von den lateralen Begrenzungen mehrerer in aufeinanderfolgenden Verfahrensschritten aufgebrachten Teilstrukturen ab, wobei sich die beim Definieren derselben vorgegebenen lateralen Toleranzen unter Umständen zueinander addieren. Diese Toleranzen, die insbesondere auf nicht beherrschbare Fehler in der Justierung von Fotomasken zurückgehen, führen dazu, daß die angestrebte kurze Kanallänge nicht mit so großer Sicherheit erreicht werden kann, wie es in vielen Fällen wünschenswert wäre.

Andere bekannte Feldeffekttransistoren mit noch kürzerer Kanallänge werden nach der in dem Technical Digest IEDM 1977, S. 399-401 beschriebenen DIMOS-Technologie hergestellt. Hierbei wird eine doppelte Implantation von Dotierungsstoffen nach dem Plazieren eines insbesondere mit abgeschrägten Kanten ausgebildeten Gate vorgenommen. Es entstehen unmittelbar neben dem Gate liegende Source- und Draingebiete, wobei unterhalb des Sourcegebietes eine Zone gebildet wird, die eine der Grunddotierung des Halbleiterkörpers bezüglich des Leitfähigkeitstyps entsprechende, jedoch einen höheren Dotierungsgrad aufweisende Dotierung erhält. Unterhalb einer abgeschrägten Kante des Gate weist diese Zone einen Randbereich auf, der sich bis zu der Grenzfläche des Halbleiterkörpers, die durch die das Gate tragende Isolierschicht abgedeckt ist, hin erstreckt. Der Randbereich stellt dann in seinem der Grenzfläche benachbarten Teil den sehr kurzen wirksamen Kanalbereich des Transistors dar. Bei diesen Feldeffekttransistoren ist jedoch eine relativ große Kapazität zwischen dem Sourcegebiet und dem Halbleiterkörper vorhanden, ebenso eine relativ große Millerkapazität zwischen dem Gate und dem Draingebiet.

Feldeffekttransistoren mit kurzer wirksamer Kanallänge werden bei der analogen Verarbeitung von elektrischen Signalen überall dort benötigt, wo es auf eine hohe Steilheit und einen hohen Innenwiderstand ankommt. Hierbei werden auch möglichst kleine Kapazitäten zwischen dem Sourcegebiet, dem Draingebiet und dem Gate einerseits und dem Halbleiterkörper andererseits angestrebt.

Der Erfindung liegt die Aufgabe zugrunde, einen Feldeffekttransistor anzugeben, der bezüglich der wirksamen Kanallänge und der unerwünschten Millerkapazität einen besonders günstigen Kompromiß darstellt. Hierzu wird erfindungsgemäß ein Feldeffekttransistor der eingangs genannten Art vorgesehen, der die im kennzeichnenden Teil des Anspruchs 1 angegebenen Merkmale aufweist.

Der mit der Erfindung erzielbare Vorteil besteht insbesondere darin, daß eine kurze wirksame Kanallänge mit wesentlich größerer Sicherheit realisiert werden kann als bei den bekannten Feldeffekttransistoren mit zwei Gateelektroden, wobei aber die zwischen dem Sourcegebiet und dem Gate einerseits und dem Halbleiterkörper andererseits sowie die zwischen dem Gate und dem Draingebiet auftretenden unerwünschten Kapazitäten kleiner sind als bei den in DIMOS-Technologie hergestellten Transistoren. Ein anderer Vorteil gegenüber DIMOS-Transistoren ist darin zu sehen, daß der bei diesen vorhandene begrenzende Deffekt bezüglich des maximalen Drainstroms durch eine hinreichend hohe Vorspannung am zweite Gate weitgehend ausgeschaltet wird, so daß die kurze wirksame Kanallänge hinsichtlich der erreichbaren Steilheit voll ausgenutzt werden kann. Weiterhin läßt sich der erfindungsgemäße Transistor nach Verfahren herstellen, die mit der Doppel-Silizium-Gate-Technologie kompatibel sind, so daß die gleichzeitige Herstellung erfindungsgemäßer Transistoren mit anderen in der genannten Technologie gefertigten Bauelementen ohne Schwierigkeiten möglich ist. Der Anspruch 2 gibt eine Ausführungsform der Erfindung an, bei der die Sperrschichtkapazitäten des Transistors weiter verringert sind. Die Ansprüche 3 bis 6 sind auf Weiterbildungen der Erfindung gerichtet, die eine besonders hohe Steilheit des Transistors gewährleisten, während der Anspruch 7 eine Ausführungsform des erfindungsgemäßen Transistors betrifft, die eine besonders hohe Durchbruchspannung besitzt. Die Ansprüche 8 und 9 haben vorteilhafte Verfahren zur Herstellung von Feldeffekttransistoren nach der Erfindung zum Gegenstand.

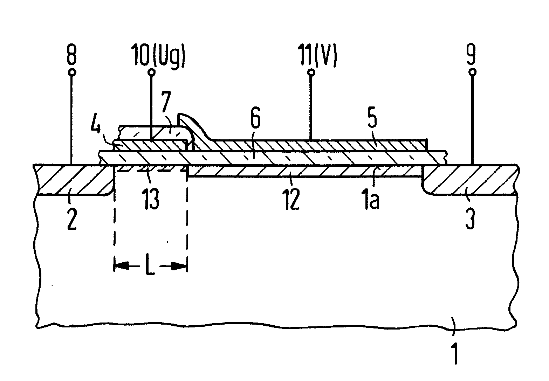

In der Zeichnung ist ein Längsschnitt durch einen nach der Erfindung ausgebildeten Feldeffekttransistor dargestellt.

Dabei ist ein Halbleiterkörper 1 vorgesehen, der z. B. aus p-dotiertem Silizium besteht. An einen mit 1a bezeichneten Grenzfläche desselben befinden sich ein $n^+$-dotiertes Sourcegebiet 2 und $n^+$-dotiertes Draingebiet 3. Der zwischen diesen Gebieten liegende Halbleiterbereich wird von einem ersten Gate 4 und einem zweiten Gate 5 überdeckt, die durch eine dünne elektrisch isolierende Schicht 6 von der Grenzfläche 1a getrennt sind. Zwischen dem Gate 4 und dem Gate 5 befindet sich eine zweite elektrisch isolierende Schicht 7. Im betrachteten Ausführungsbeispiel bestehen die isolierenden Schichten 6 und 7 vorzugsweise aus $SiO_2$. Die Gebiete 2 und 3 sowie das Gate 4 und das Gate 5 sind mit elektrischen Anschlüssen 8, 9, 10 und 11 versehen.

Unterhalb des Gate 5 ist an der Grenzfläche 1a eine n-dotierte Zone 12 vorgesehen, die an das Gebiet 3 unmittelbar anschließt. Die Herstellung dieser Zone erfolgt zweckmäßigerweise mittels eines Dotierungsschritts, der nach dem Plazieren des Gate 4 vorgenommen wird und bei dem das Gate 4 als Dotierungsmaske dient. Auf diese Weise bestimmt das Gate 4 mit seiner in Source-Drain-Richtung gemessenen Länge die vom Sourcegebiet 2 bis zu der nächstliegenden Grenze der Zone 12 reichende wirksame Kanallänge L des Transistors mit großer Genauigkeit. Erst nach der Erzeugung der Zone 12 wird dann das Gate 5 aus einer auf den isolierenden Schichten 6 und 7 aufgebrachten elektrisch leitenden Belegung gebildet. Dabei überlappt ein Teil dieser Belegung das Gate 4.

In einem ersten Betriebsfall werden der Anschluß 8 an ein festes Bezugspotential, z. B. Massepotential, gelegt, der Anschluß 9 an eine positive Spannung $V_D$ und der Anschluß 11 an eine positive Vorspannung V, während dem Anschluß 10 eine Leitfähigkeit des mit L bezeichneten, kurzen Teilkanals steuernde Gatespannung Ug zugeführt wird. Dabei steuert die Gatespannung Ug den Ladungsträgertransport zwischen den Gebieten 2 und 3. In einem anderen Betriebsfall liegen der Anschluß 9 an einer Versorgungsspannung $V_{DD}$ und der Anschluß 8 an einer Spannung $U_S$, während dem Anschluß 11 eine Vorspannung V und dem Anschluß 10 eine die Leitfähigkeit des Teilkanals steuernde Gatespannung Ug zugeführt werden.

Zur näheren Erläuterung der Erfindung werden im folgenden einige Dotierungsbeispiele angegeben. Dabei wird zunächst von einem p-dotierten Halbleiterkörper ausgegangen, der eine Grunddotierung aufweist, bei der eine Störstellenkonzentration von etwa $10^{15}$ bis $10^{16}$ cm$^{-3}$ vorhanden ist. Die Gebiete 2 und 3 weisen eine $n^+$-Dotierung mit einer Störstellenkonzentration von etwa $10^{17}$ cm$^{-3}$ auf, die Zone 12 eine n-Dotierung mit einer Störstellenkonzentration von etwa $7,5 \cdot 10^{14}$ bis $5 \cdot 10^{15}$ cm$^{-3}$. Bei einer Ausbildung des Gate 4 mit einer dem Maß L entsprechenden Länge von etwa 1 µ bis 2 µm ergibt sich eine Steilheit $g_m$ des Transistors, die größer ist als $10^{-4}$ A/V.

Baut man den Transistor auf einem Halbleiterkörper 1 auf, der eine p-Grunddotierung mit einer Störstellenkonzentration von etwa $1 \cdot 10^{14}$ cm$^{-3}$ bis $10^{15}$ cm$^{-3}$ aufweist und lediglich an seiner Grenzfläche 1a eine stärkere p-Dotierung 13 von etwa $5 \cdot 10^{15}$ cm$^{-3}$ bis $1,5 \cdot 10^{16}$ cm$^{-3}$ besitzt, so wirkt sich letztere nur in dem von dem Gate 4 überdeckten Teilkanal der Länge L aus. Dabei verringern sich die Sperrschichtkapazitäten der Gebiete 2 und 3 gegenüber dem Halbleiterkörper 1 unter gleichzeitiger Verringerung des Substratsteuereffekts, wobei der oben genannte Wert der Steilheit $g_m$ ebenfalls erreicht wird.

Wird bei dem vorstehend beschriebenen und in der Zeichnung dargestellten Transistor die Dicke der isolierenden Schicht 6 unterhalb des Gate 4 verringert, so erhöht sich die Steilheit $g_m$. Bei Zuführung einer Vorspannung V einstellbarer Größe gelingt es weiterhin, die Steilheit gm mit größerwerdender Vorspannung V zu erhöhen.

Um dem Transistor nach der Erfindung eine hohe Durchbruchspannung zu geben, ist es zweckmäßig, die n-Dotierung der Zone 12 soweit anzuheben, daß sie eine Störstellenkonzentration von $10^{15}$ bis $10^{18}$ cm$^{-3}$ aufweist.

In Abweichung von den bisher beschriebenen Ausführungsformen kann der Transistor nach der Erfindung auch auf einem n-dotierten Halbleiterkörper 1 aufgebaut werden. Hierbei kehren sich dann die Leitfähigkeitstypen der einzelnen Halbleiterbereiche jeweils um, wobei auch Betriebsspannungen der entgegengesetzten Polarität vorzusehen sind. Das erste Gate 4 und das zweite Gate 5 bestehen zweckmäßigerweise aus stark dotiertem, polykristallinem Silizium, können aber auch als metallische Belegungen ausgeführt sein. Bei der Herstellung eines Feldeffekttransistors nach der Erfindung wird zweckmäßigerweise von einem z. B. mit einer p-Grunddotierung versehen Halbleiterkörper 1 ausgegangen, der an seiner Grenzfläche 1a eine höhere p-Dotierung aufweist als in seinen übrigen Teilen. Dieser Halbleiterkörper wird mit einer die Grenzfläche 1a abdeckenden, elektrisch isolierenden Schicht 6 versehen, z. B. einer Gateoxidschicht, die in lateraler Richtung von einer den Transistorbereich begrenzenden Feldoxidschicht umgeben ist. Unterhalb der letzteren befindet sich im allgemeinen noch eine Feldimplantation. Hiervon ausgehend wird auf der Schicht 6 zunächst ein die wirksame Kanallänge L definierendes Gate 4 plaziert. Dann wird die Zone 12 durch einen Dotierungsschritt, z. B. eine Ionenimplantation, erzeugt, wobei das Gate 4 eine erste Dotierungsmaske darstellt. Nach dem Aufbringen einer das Gate 4 abdeckenden Isolierschicht 7 wird eine elektrisch leitende Belegung auf den Schichten 6 und 7 aufgebracht, aus der mittels fotolithografischer Schritte das Gate 5 gebildet wird. Es folgt ein weiterer Dotierungsschritt zur Bildung der Source- und Draingebiete 2 und 3, wobei sowohl das Gate 4 als auch das Gate 5 zusammen mit der Feldoxidschicht Teile einer zweiten Dotierungsmaske darstellen. Danach werden die Gebiete 2 und 3 sowie das Gate 4 und das Gate 5 mit den elektrischen Anschlüssen 8 bis 11 versehen.

Wird von einem Halbleiterkörper 1 ausgegangen, der homogen dotiert ist, und zwar mit einem Dotierungsgrad, der oben genannten p-Dotierung an der Grenzfläche 1a etwa entspricht, so erhöhen sich die Sperrschichtkapazitäten zwischen den Gebieten 2 und 3 und dem Halbleiterkörper 1.

**Ansprüche**

1. Feldeffekttransistor, der an der Grenzfläche eines mit einer Grunddotierung versehenen Halbleiterkörpers liegende, zu der Grunddotierung entgegengesetzt dotierte Source- und Draingebiete (2 und 3) sowie ein erstes (4) und ein zweites Gate (5) aufweist, die jeweils einen Teil des zwischen den Gebieten (2, 3) liegenden Halbleiterbereiches überdecken und von diesem durch eine elektrisch isolierende Gateisolierschicht (6) getrennt sind, bei dem das erste Gate (4) sourceseitig selbstjustierend angeordnet und mit einer Steuerspannung beschaltet ist, während das zweite Gate (5) drainseitig selbstjustierend angeordnet und mit einer Vorspannungsquelle verbunden ist, bei dem das zweite Gate (5) aus einer elektrisch leitenden Belegung besteht, die teilweise oberhalb des ersten Gate (4) angeordnet und durch eine zweite elektrisch isolierende Schicht (7) von diesem getrennt ist, bei dem der von dem ersten Gate (4) nicht bedeckte Teil des zwischen den Gebieten (2, 3) liegenden Halbleiterbereiches mit einer der Grenzfläche (1a) benachbarten Zone (12) versehen ist, die eine zu der Grunddotierung entgegengesetzte Dotierung aufweist, und bei dem der Kanalbereich zwischen dem Sourcegebiet (2) und der benachbarten Zone (12) liegt und vom Sourcegebiet (2) und von der benachbarten Zone (12) begrenzt ist, dadurch gekennzeichnet, daß das erste Gate (4) mit einer der Länge (L) des Kanalbereiches gleichen Abmessung in Source-Drain-Richtung ausgebildet ist.

2. Feldeffekttransistor nach Anspruch 1, dadurch gekennzeichnet, daß der von dem ersten Gate (4) bedeckte Teil des Halbleiterkörpers (1) an der Grenzfläche (1a) einen höheren Dotierungsgrad aufweist als der Grunddotierung entspricht.

3. Feldeffekttransistor nach den Ansprüchen 1 oder 2, dadurch gekennzeichnet, daß der Dotierungsgrad des von dem ersten Gate (4) bedeckten Teils des Halbleiterkörpers (1) an der Grenzfläche (1a) höher gewählt ist als der Dotierungsgrad der Zone (12).

4. Feldeffekttransistor nach einem der Ansprüche 1 bis 3, dadurch gekennzeichnet, daß die Gateisolierschicht (6) unterhalb des ersten Gate (4) eine kleinere Dicke aufweist als unterhalb des zweiten Gate (5).

5. Feldeffekttransistor nach einem der Ansprüche 1 bis 4, dadurch gekennzeichnet, daß die mit dem zweiten Gate (5) verbundene Vorspannungsquelle bezüglich der Größe der Vorspannung (V) einstellbar ausgebildet ist.

6. Feldeffekttransistor nach einem der Ansprüche 3 bis 5, dadurch gekennzeichnet, daß die Störstellenkonzentration des von dem ersten Gate (4) bedeckten Teils des Halbleiterkörpers (1) an der Grenzfläche (1a) etwa um zwei Größenordnungen über dem Wert liegt, der der Grunddotierung entspricht, und daß die Störstellenkonzentration der Zone (12) über dem Wert liegt, der der Grunddotierung entspricht, wobei der Konzentrationsunterschied etwa bis zu einer Größenordnung beträgt.

7. Feldeffekttransistor nach einem der vorhergehenden Ansprüche, dadurch gekennzeichnet, daß die Zone (12) eine Störstellenkonzentration aufweist, die über dem Wert liegt, der der Grunddotierung entspricht, wobei der Konzentrationsunterschied bis zu vier Größenordnungen beträgt.

8. Verfahren zur Herstellung eines Feldeffekttransistors nach Anspruch 1, dadurch gekennzeichnet, daß ein mit einer Grunddotierung versehener Halbleiterkörper (1) an einer Grenzfläche mit einer elektrisch isolierenden Gateisolierschicht (6) abgedeckt wird, daß auf dieser Gateisolierschicht (6) ein erstes Gate (4) mit einer der Länge (L) des Kanalbereiches gleichen Abmessung in Source-Drain-Richtung plaziert wird, daß die benachbarte Zone (12) durch einen Dotierungsvorgang gebildet wird, beidem das erste Gate (4) einen Teil einer ersten Dotierungsmaske darstellt, daß nach dem Abdecken des ersten Gate (4) mittels einer zweiten elektrisch isolierenden Schicht (7) ein zweites Gate (5) derart auf der Gateisolierschicht (6) und der zweiten elektrisch isolierenden Schicht (7) plaziert wird, daß es das erste Gate (4) teilweise überlappt, daß mittels eines weiteren Dotierungsvorgangs das Source- und das Draingebiet (2 und 3) erzeugt werden, wobei Teile des ersten und zweiten Gate (4 und 5) als Teile einer zweiten Dotierungsmaske dienen, und daß das Sourcegebiet (2), das Draingebiet (3), das erste (4) und das zweite Gate (5) mit elektrischen Anschlüssen (8 bis 11) versehen werden.

9. Verfahren nach Anspruch 8 zur Herstellung eines Feldeffekttransistors nach Anspruch 2, dadurch gekennzeichnet, daß der Halbleiterkörper (1) an der mit der Gateisolierschicht (6) abgedeckten Grenzfläche mit einem höheren Dotierungsgrad dotiert wird als in seinen übrigen Teilen.

**Claims**

1. A field effect transistor which has source and drain zones (2 and 3) arranged at the boundary surface of a semiconductor body having a basic doping, and which zones are oppositely doped to the basic doping, and first (4) and second gates (5) which respectively cover a section of the semiconductor region lying between the zones (2, 3) and are separated from said semiconductor region by an electrically-insulating gate insulation layer (6), wherein at the source side, the first gate (4) is arranged to be self-aligning and is connected to a control voltage, whilst at the drain side, the second gate (5) is arranged so as to be self-aligning and is connected to a bias voltage source, wherein the second gate (5) consists of an electrically-conductive coating which is partially arranged above the first gate (4) and separated therefrom by a second electrically-insulating layer (7), wherein the part of the semiconductor region lying between the zones (2, 3) which is not covered by the first gate (4), is provided with a zone (12) which is adjacent to the boundary surface (1a) and is oppositely doped to the basic doping, and wherein the channel region is arranged between and is bounded by the source zone (2) and the adjacent zone (12), characterised in that the first gate (4) is formed so as to have a dimension in the source-drain direction which corresponds to the length (L) of the channel region.

2. A field effect transistor as claimed in Claim 1, characterised in that, at the boundary surface (1a), the part of the semiconductor body (1) which is covered by the first gate (4), has a higher doping value than that of the basic doping.

3. A field effect transistor as claimed in Claim 1 or Claim 2, characterised in that, at the boundary surface (1), doping value of the part of the semiconductor body (1) which is covered by the first gate (4) is selected to be higher than the doping value of the zone (12).

4. A field effect transistor as claimed in one of Claims 1 to 3, characterised in that, below the first gate (4), the gate insulating layer (6) has a smaller thickness than it has below the second gate (5).

5. A field effect transistor as claimed in one of Claims 1 to 4, characterised in that the bias voltage source connected to the second gate (5) is adjustable in respect of the magnitude of the bias voltage (V).

6. A field effect transistor as claimed in one of Claims 3 to 5, characterised in that, at the boundary surface (1a), the impurity concentration of the part of the semiconductor body (1) which is covered by the first gate (4) lies above the value corresponding to the basic doping, by approximately two order of magnitudes ; and that the impurity concentration of zone (12) lies above the value corresponding to the basic doping, the difference in concentration amounting approximately to up to one order of magnitude.

7. A field effect transistor as claimed in one of the preceding Claims, characterised in that the zone (12) has an impurity concentration which lies above the value corresponding to the basic doping, the difference in concentration amounting to up to four orders of magnitude.

8. A process for the production of a field effect transistor as claimed in Claim 1, characterised in that a semiconductor body (1) having a basic doping is covered on a boundary surface thereof with an electrically-insulating gate insulation layer (6) ; that a first gate (4), having a dimension in the source-drain direction which corresponds to the length (L) of the channel region, is applied to the gate insulation layer (6) ; that the adjacent zone (12) is formed by means of a doping operation in which the first gate (4) represents a part of a first doping mask ; that after the covering of the first gate (4) with a second electrically-insulating layer (7), a second gate (5) is applied to the gate insulation layer (6) and the second electrically-insulating layer (7) in such a way that it partially overlaps the first gate (4) ; that the source and drain zones (2 and 3) are produced by means of a further doping operation in which parts of the first and second gates (4 and 5) serve as parts of a second doping mask ; and that the source zone (2), the drain zone (3), the first gate (4) and the second gate (5) are provided with electrical terminals (8 to 11).

9. A process as claimed in Claim 8 for the production of a field effect transistor as claimed in Claim 2, characterised in that, at the boundary surface covered with the gate insulation layer (6), the semi-conductor body (1) is doped to a higher doping level than in its remaining parts.

**Revendications**

1. Transistor à effet de champ, qui comporte des régions de source et de drain (2 et 3) situées à la face limite d'un corps semiconducteur pourvu d'un dopage de fond et possédant un dopage opposé à celui du dopage de fond, ainsi qu'une première (4) et une seconde grilles (5) qui recouvrent respectivement une partie de la région semiconductrice située entre les régions (2 et 3) et qui sont isolées de cette dernière par une couche d'isolation de grille (6) électriquement isolante, dans lequel la première grille (4) est disposée de manière à être auto-réglable du côté de la source, alors que la seconde grille (5) est disposée de manière à être auto-réglable du côté du drain et est reliée à une source de polarisation, dans lequel la seconde grille (5) est constituée par un revêtement électriquement conducteur, disposé en partie au-dessus de la première grille (4) et est isolé de cette dernière par une seconde couche électriquement isolante (7), dans lequel la région semiconductrice située entre les régions (2 et 3) et non recouverte par la première grille (4) est pourvue d'une région (12) qui est voisine de la surface limite (1a) et qui présente un dopage opposé au dopage de fond, et dans lequel la région de canal se situe entre la région de source (2) et la région voisine (12) et est limitée par la région de source (2) et par la région voisine (12), caractérisé par le fait que la première grille (4) est réalisée avec une dimension, dans la direction source-drain, qui est identique à la longueur (L) de la région de canal.

2. Transistor à effet de champ selon la revendication 1, caractérisé par le fait que la partie du corps semiconducteur (1) qui est recouverte par la première grille (4) présente, au niveau de la surface-limite (1a), un degré de dopage supérieur à celui du dopage de fond.

3. Transistor à effet de champ selon les revendications 1 ou 2, caractérisé par le fait que le degré de dopage de la partie du corps semiconducteur (1), qui est recouverte par la première grille (4), est choisi, à la surface-limite (1a), à un degré plus élevé que le degré de dopage de la zone (12).

4. Transistor à effet de champ selon l'une des revendications 1 à 3, caractérisé par le fait que la couche isolante de grille (6), en-dessous de la première grille (4), présente une épaisseur plus faible qu'en-dessous de la seconde grille (5).

5. Transistor à effet de champ selon l'une des revendications 1 à 4, caractérisé par le fait que la source de tension de polarisation qui est reliée à la seconde grille (5) est réalisée de façon à être réglable par rapport à l'importance de la tension de polarisation (V).

6. Transistor à effet de champ selon l'une des revendications 3 à 5, caractérisé par le fait que la concentration des impuretés de la partie du corps semiconducteur (1), qui est reliée par la première grille (4), se situe à peu près de deux ordres de grandeur au-delà de la valeur qui correspond au dopage de fond, et que la concentration des impuretés de la zone (12) se situe au-delà de la valeur qui correspond au dopage de fond, la différence en concentrations étant à peu près jusqu'à un ordre de grandeur.

7. Transistor à effet de champ selon l'une des revendications précédentes, caractérisé par le fait que la zone (12) présente une concentration en impuretés qui se situe au-delà de la valeur qui correspond au dopage de fond, la différence en concentrations étant jusqu'à quatre ordres de grandeurs.

8. Procédé pour la fabrication d'un transistor à effet de champ selon la revendication 1, caractérisé par le fait qu'un corps semiconducteur (1), pourvu d'un dopage de fond, est recouvert, au niveau de la surface-limite, d'une couche isolante de grille (6), électriquement isolante, que sur cette couche de grille isolante (6) est placée une première grille (15) ayant une dimension, dans la direction source-drain égale à la longueur (L) de la région de canal, que la région voisine (12) est formée par une opération de dopage dans laquelle la première grille (4) représente une partie d'un premier masque de dopage, qu'après couverture de la première grille (4) à l'aide d'une seconde couche électriquement isolante (7), on place une seconde grille (5) de telle façon sur la couche isolante de grille (6) et sur la couche électriquement isolante (7), qu'elle chevauche partiellement la première grille (4), qu'à l'aide d'une autre opération de dopage, on réalise les régions de source et de drain (2 et 3), des parties de la première et de la seconde grilles (4 et 5) servant comme parties d'un second masque de dopage, et que la région de source (2), la région de drain (3), la première (4) et la seconde grilles (5) sont pourvues de bornes de raccordement électrique (8 à 11).

9. Procédé selon la revendication 8 pour la fabrication d'un transistor à effet de champ selon la revendication 2, caractérisé par le fait que le corps semiconducteur (1) est dopé, au niveau de la surface-limite qui est recouverte avec la couche isolante de grille (6), avec un degré de dopage qui est supérieur à celui des autres parties.